# FASCICULE DE BREVET EUROPEEN

(11) **EP 0 626 800 B1**
(45) Date de publication et mention de la délivrance du brevet: **16.07.1997**
(21) Numéro de dépôt: 94401166.7
(22) Date de dépôt: 26.05.1994
(51) Int. Cl.: H05K 7/14

(54) **Dispositif support extractible pour équipement électronique**
Herausziehbare Halterung für elektronische Baugruppen
Extractable supporting device for electronic equipment

(30) Priorité: 28.05.1993 FR 9306428
(43) Date de publication de la demande: 30.11.1994
(73) Titulaire: ALCATEL MOBILE COMMUNICATION FRANCE, 75008 Paris (FR)
(72) Inventeur: Bezieres, Alain, F-53150 Saint Cenere (FR); Villain, Jean-Christophe, F-75018 Paris (FR)
(74) Mandataire: Renaud-Goud, Thierry

(56) Documents cités:
- DE-B- 1 209 626
- US-A- 5 010 426
- US-A- 5 208 735

## Description

L'invention porte sur un dispositif support extractible comprenant un boîtier tiroir muni d'une poignée ayant deux bras montés chacun à rotation autour d'un axe et occupant ensembles une première position dans laquelle ils s'étendent sensiblement parallèlement à une face du boîtier tiroir et une seconde position dans laquelle ils s'étendent sensiblement perpendiculairement à ladite face du boîtier tiroir, le boîtier tiroir étant destiné à s'insérer dans un boîtier fourreau.

Un tel dispositif est destiné en premier lieu à être installé dans un véhicule, un équipement électronique tel qu'un émetteur/récepteur de radiotéléphone étant encastré dans le boîtier tiroir. Il permet un montage rapide de l'équipement électronique dans le véhicule et son démontage en cas de besoin par simple extraction du boîtier tiroir hors du boîtier fourreau.

Un tel dispositif est couramment disponible dans le commerce. Le boîtier tiroir est généralement équipé d'un connecteur électrique agencé pour s'insérer à force dans un connecteur électrique complémentaire prévu sur le boîtier fourreau fixé à demeure dans le véhicule.

L'extraction du boîtier tiroir hors du boîtier fourreau se fait en exerçant une force de traction sur la poignée, les bras de la poignée occupant alors la seconde position. Il est nécessaire d'exercer une force de traction importante pour que les connecteurs électriques se désolidarisent entre eux, sachant que dans le cas d'un émetteur/récepteur de radiotéléphone, les broches de connexion électriques sont nombreuses (21 points généralement). Par ailleurs, la force de traction exercée par un utilisateur sur la poignée est généralement beaucoup plus importante que celle nécessaire à la désolidarisation des connecteurs électriques, ce qui provoque dans le temps l'endommagement des connecteurs électriques et de la poignée.

Le document de brevet DE-B-1,209,626 divulgue un dispositif support extractible du type ci-dessus, dans lequel chaque bras de la poignée a une extrémité libre agencée pour venir en appui contre le boitier fourreau lorsque ledit bras est déplacé entre sa première position et sa seconde position de manière à déplacer le boîtier tiroir par rapport au boîtier fourreau par un effet de came.

Contrairement aux dispositifs support extractibles connus, la désolidarisation des connecteurs électriques ne se fait alors plus par une traction sur la poignée dans la direction d'insertion du boîtier tiroir dans le boîtier fourreau, mais par un effet de came dû à la rotation des bras de la poignée autour de leur axe de rotation. Ainsi, l'utilisateur peut facilement maîtriser la force nécessaire à exercer sur la poignée pour désolidariser les connecteurs électriques. Du fait que la poignée ne subit plus d'efforts excessifs, elle peut être conçue plus légère.

Par ailleurs, dans les dispositifs supports extractibles connus, les connecteurs électriques sont verrouillés en position d'insertion par l'effet de forces de frottement sur les broches de connections électriques des connecteurs électriques. L'inconvénient d'un tel moyen de verrouillage est de conduire rapidement à la détérioration des broches de connexion électrique lorsque le boîtier tiroir est souvent extrait du boîtier fourreau. Pour remédier à cet inconvénient, le document de brevet mentionné prévoit un moyen pour verrouiller en position d'insertion les connecteurs électriques comprenant un verrou solidaire du boîtier fourreau et sollicité élastiquement dans une encoche prévue sur le boîtier tiroir.

Toutefois, ce verrou est disposé en face avant et actionné à la main, directement.

L'invention a pour but de pallier cet inconvénient.

Selon l'invention telle que définie dans la revendication 1, le verrou est disposé en face arrière et, pour faciliter l'extraction du boîtier tiroir hors du boîtier fourreau, il est prévu un moyen de déverrouillage pour dégager le verrou hors de l'encoche.

Selon un mode de réalisation particulièrement simple, une plaque coulissante à l'intérieur du boîtier fourreau est prévue pour faire tourner ledit verrou autour de son axe de manière à le dégager hors de l'encoche, cette plaque étant disposée à l'intérieur du boîtier fourreau de manière à coulisser sous l'effet d'une force de poussée exercée par l'extrémité libre d'un bras de la poignée lorsque celui-ci est déplacé entre sa première position et sa seconde position.

Le déverrouillage des connecteurs électriques et l'extraction du boîtier tiroir hors du boîtier fourreau sont obtenus par une seule action sur la poignée grâce à une butée solidaire du boîtier fourreau qui est prévue pour limiter le déplacement en translation de la plaque par rapport au boîtier fourreau.

Selon une autre caractéristique de l'invention, un ressort est prévu pour agir à l'encontre du déplacement en translation de la plaque par rapport au boîtier fourreau.

Si le verrou n'est pas correctement en prise dans l'encoche, le boîtier tiroir sort du boîtier fourreau sous l'action du ressort contre la plaque. L'utilisateur peut donc contrôler visuellement une insertion correcte du boîtier tiroir dans le boîtier fourreau. Par ailleurs, lorsque le verrou est maintenu hors de l'encoche par la plaque, le ressort exerce une force de poussée sur le boîtier tiroir par l'intermédiaire de la plaque, ce qui provoque l'éjection du boîtier tiroir hors du boîtier fourreau. Enfin, lorsque le boîtier tiroir est complètement inséré dans le boîtier fourreau, la plaque sous l'action du ressort, force le bras à occuper la seconde position par un effet de came. La face avant du boîtier tiroir reste donc dégagée quand le boitier tiroir est complètement inséré dans le boitier fourreau.

L'invention est maintenant décrite en détail ci-dessous en référence aux dessins.

La figure 1 est une vue de côté du boîtier tiroir.

La figure 2 est une vue de côté en coupe longitudinale du boîtier fourreau.

Les figures 3 à 7 illustrent différentes positions du boîtier tiroir de la figure 1 dans le boîtier fourreau de la figure 2.

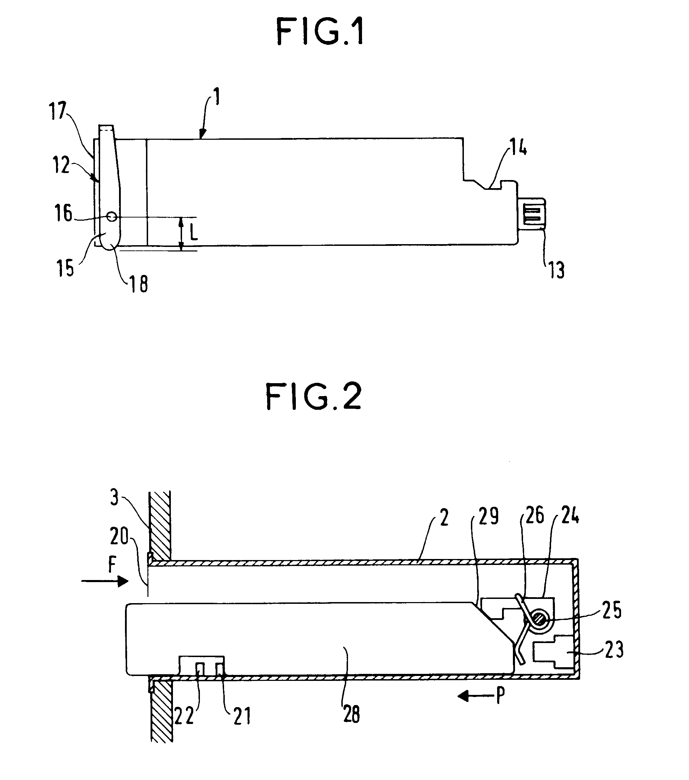

Le dispositif support extractible selon l'invention comprend d'une part un boîtier tiroir visible sur la figure 1 et un boîtier fourreau visible sur la figure 2. Le boîtier tiroir vient à s'insérer dans le boîtier fourreau.

Le boîtier tiroir 1 présente une forme sensiblement parallélépipédique ayant des côtés avant, arrière, latéraux, supérieur et inférieur.

Il est muni à l'avant d'une poignée 12 en forme de U ayant deux bras 15 montés chacun à rotation autour d'un axe 16 solidaire d'un côté latéral. Les deux bras peuvent se déplacer entre une position dite rabattue qu'ils occupent lorsqu'ils s'étendent sensiblement parallèlement au côté avant 17 du boîtier tiroir et une position dite déployée qu'ils occupent lorsqu'ils s'étendent sensiblement perpendiculairement audit côté avant du boîtier tiroir.

Le boîtier tiroir est aussi muni sur son côté arrière d'un connecteur électrique 13 à broches par exemple.

Une encoche 14 est formée sur les côtés supérieurs du boîtier tiroir à l'arrière de celui-ci par moulage ou analogue.

Le bras 15 visible sur la figure 1 présente une extrémité libre 18 qui s'étend sur une longueur L au delà de l'axe 15. Cette extrémité libre sert de bras de levier pour extraire le boîtier tiroir hors du boîtier fourreau. Il est entendu que les deux bras 15 présentent les mêmes caractéristiques.

Le boîtier fourreau 2 présente aussi une forme parallélépipédique ayant des côtés avant, arrière, latéraux, supérieur et inférieur.

Le côté avant 20 du boîtier 2 est ouvert. Le boîtier tiroir est donc inséré dans le boîtier fourreau par son côté avant comme indiqué par la flèche F.

Lorsque le boîtier fourreau est encastré dans la console d'un véhicule, son côté avant 20 se trouve sensiblement dans le même plan que le panneau 3 de la console du véhicule.

Le boîtier fourreau est muni sur son côté arrière d'un connecteur électrique 23 complémentaire du connecteur électrique 13.

Chaque côté latéral du boîtier fourreau, porte à l'arrière, un verrou 24 en forme de L monté à rotation sur un axe 25. Le verrou se déplace en rotation dans un plan parallèle à un côté latéral du boîtier fourreau. La branche du L de chaque verrou est destinée à venir s'introduire dans l'encoche 14 du boîtier tiroir lorsque celui-ci est complètement inséré dans le boîtier fourreau, les connecteurs 13 et 23 étant aussi insérés l'un dans l'autre.

Chaque axe 25 d'un verrou porte un ressort à enroulement 26 dont une extrémité est plaquée sur le tronc du L du ressort et l'autre extrémité est laissée libre.

Le long de chaque côté latéral du boîtier fourreau, une plaque 28 est montée coulissante sur une glissière par exemple. Lorsque le boîtier tiroir est inséré dans le boîtier fourreau, chaque plaque 28 est disposée entre un côté latéral du boîtier tiroir et le même côté latéral du boîtier fourreau.

Chaque plaque 28 s'étend sensiblement entre l'axe 25 d'un verrou et le côté avant du boîtier fourreau. L'extrémité du L du verrou vient en appui contre une rampe 29 formée sur la face arrière de la plaque 28. Par ailleurs, l'extrémité libre du ressort 26 vient aussi en appui sur la face arrière de la plaque 28 et exerce une force de poussée sur celle-ci indiquée par la flèche P. Par conséquent, l'extrémité du L du verrou est en permanence appuyée contre la rampe de la plaque 28 sous l'action du ressort 26.

Deux butées 22,21, pour chaque plaque 28, sont prévues sur le côté inférieur du boîtier fourreau pour limiter le déplacement en translation de la plaque. Ces deux butées sont éloignées d'une distance inférieure à la distance L de sorte que la course de la plaque 28 est aussi inférieure à la distance L.

Comme visible sur la figure 2, la plaque 28, au repos, vient en appui sur la butée 21 sous l'effet de la force de poussée exercée par le ressort 26 sur son extrémité arrière. Dans cette position, la plaque 28 maintient le tronc du ressort sensiblement parallèle au côté supérieur du boîtier fourreau.

Si maintenant la plaque 28 est coulissée de l'avant vers l'arrière du boîtier fourreau, la rampe 29 de la plaque soulève la branche du L du verrou par effet de pivotement de celui-ci autour de son axe 25. Par ailleurs, l'extrémité arrière de la plaque 28 comprime le ressort 26. Le déplacement de la plaque 28 est limité par la butée 22.

Si maintenant, la plaque est laissée libre, elle revient à sa position de repos en appui contre la butée 21.

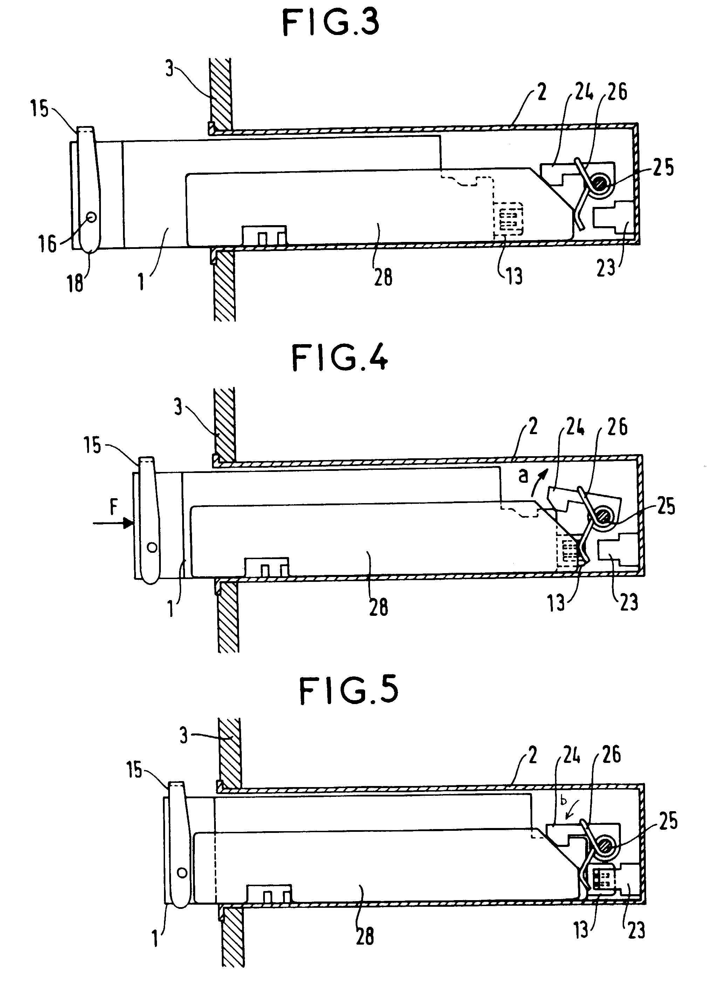

Sur la figure 3, le boîtier tiroir 1 est en partie introduit dans le boîtier fourreau 2. Les bras 15 de la poignée occupent une position rabattue. Les plaques 28 sont en appui contre les butées 21. Les verrous 24 sont en appui contre les rampes 29 des plaques 28.

Sur la figure 4, le boîtier tiroir 1 est encore avancé dans le boitier fourreau selon la direction indiquée par la flèche F. Il a son côté arrière qui vient alors en contact avec la branche du L des verrous 24 ce qui pour effet de les faire pivoter autour de leur axe 25 comme indiqué par la flèche a. Le ressort 26 est comprimé.

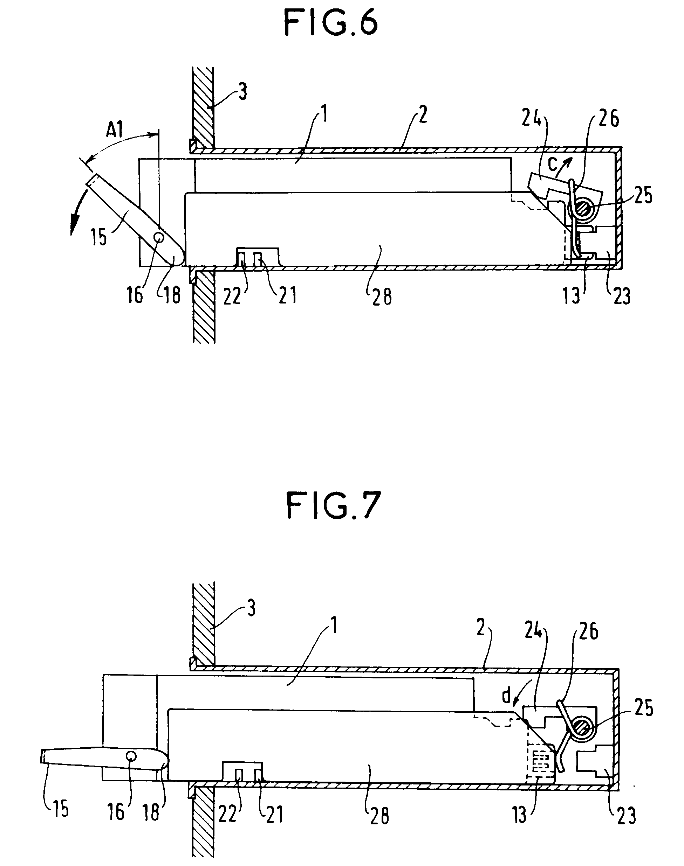

Sur la figure 5, le boîtier tiroir est complètement inséré dans le boîtier fourreau. Les connecteurs électriques 13 et 23 sont insérés l'un dans l'autre. Les verrous 24 pivotent autour de leur axe 25 comme indiqué par la flèche b. Les branches du L des verrous 24 sont donc sollicitées élastiquement dans l'encoche 14 du boîtier tiroir par les ressorts 26. Les connecteurs électriques 13,23 sont alors verrouillés en position d'insertion.

Maintenant sur la figure 6, les bras 15 de la poignée sont manoeuvrés en rotation autour de leur axe respectif 16. Ils sont déplacés d'un angle A1 depuis leur position rabattue pour occuper une position intermédiaire. Lorsque les bras 15 sont déplacés entre leur position rabattue et leur position intermédiaire, les extrémités libres 18 des bras poussent les plaques 28 qui coulissent de l'avant vers l'arrière du boîtier fourreau. Les plaques 28 sont maintenant en appui contre les butées 22. En coulissant, les plaques 28 ont dégagé les verrous 24 hors de l'encoche 14 par pivotement de ceux-ci comme indiqué par la flèche c.

Sur la figure 7, les bras 15 sont manoeuvrés en rotation autour de leur axe 16 pour occuper maintenant leur position déployée. Lorsque les bras 15 sont déplacés entre leur position intermédiaire et leur position déployée, les extrémités libres 18 des bras poussent sur l'extrémité avant des plaques 28 qui sont en appui contre les butées 22. Ceci a pour effet de déplacer le boîtier tiroir par rapport au boîtier fourreau et donc de séparer les connecteurs électriques 13,23. A ce moment, les extrémités libres des ressorts 26 poussent sur les extrémités arrières des plaques 28 ce qui a pour effet d'éjecter le boîtier tiroir hors du boîtier fourreau. En même temps, les verrous 24 pivotent autour de leur axe comme indiqué par la flèche d. Les plaques 28 viennent alors en appui contre les butées 21.

## Revendications

1. Un dispositif support extractible pour équipements électroniques comprenant un boîtier tiroir (1) et un boîtier fourreau (2), le boîtier tiroir étant muni d'une poignée (12) ayant deux bras (15) montés chacun à rotation autour d'un axe (16) et occupant ensembles une première position dans laquelle ils s'étendent sensiblement parallèlement à une face (17) du boîtier tiroir et une seconde position dans laquelle ils s'étendent sensiblement perpendiculairement à ladite face du boîtier tiroir, le boîtier tiroir étant destiné à s'insérer dans le boîtier fourreau (2), chaque bras (15) de la poignée ayant une extrémité libre (18) agencée pour venir en appui contre le boîtier fourreau lorsque ledit bras est déplacé entre sa première position et sa seconde position de manière à déplacer le boîtier tiroir par rapport au boîtier fourreau par un effet de came, dans lequel le boîtier tiroir (1) est muni d'un premier connecteur électrique (13) destiné à coopérer électriquement avec un second connecteur électrique (23) prévu sur le boîtier fourreau (2), lesdits premier et second connecteurs électriques étant agencés pour s'insérer l'un dans l'autre et un moyen (14,24) étant prévu pour verrouiller en position d'insertion lesdits premier et second connecteurs électriques entre eux lorsque le boîtier tiroir est inséré dans le boîtier fourreau, le moyen pour verrouiller en position d'insertion comprenant un verrou (24) monté à rotation sur un axe (25) solidaire du boîtier fourreau (2), ledit verrou étant sollicité élastiquement dans une encoche (14) prévue sur le boîtier tiroir (1), caractérisé en ce qu'il comprend lequel un organe de déverrouillage (28) coulissant à l'intérieur du boîtier fourreau, prévu pour faire tourner ledit verrou (24) autour de son axe de manière à le dégager hors de l'encoche (14), ledit organe de déverrouillage étant disposé à l'intérieur du boîtier fourreau de manière à coulisser sous l'effet d'une force de poussée exercée par l'extrémité libre (18) d'un bras (15) de la poignée lorsque celui-ci est déplacé entre sa première position et sa seconde position, son déplacement en translation étant limité par une butée (22) solidaire du boîtier fourreau.

2. Le dispositif selon la revendication 1, dans lequel un ressort (26) est prévu pour agir à l'encontre du déplacement en translation de l'organe de déverrouillage par rapport au boîtier fourreau.

3. Le dispositif selon la revendication 2, dans lequel le ressort (26) est monté sur l'axe 25 du verrou.

## Patentansprüche

1. Einschubvorrichtung für elektronische Geräte mit einem Einschub (1) und einem Einschubgehäuse (2), wobei der Einschub einen Griff (12) mit zwei Armen (15) enthält, die je drehbar um eine Achse (16) montiert sind und gemeinsam eine erste Stellung einnehmen können, in der sie im wesentlichen parallel zu einer Stirnseite (17) des Einschubs verlaufen, und eine zweite Stellung einnehmen können, in der sie im wesentlichen senkrecht zu dieser Stirnseite des Einschubs verlaufen, wobei der Einschub dazu bestimmt ist, in das Einschubgehäuse (2) hineingesteckt zu werden, wobei jeder Arm (15) des Griffs ein freies Ende (18) besitzt, das gegen das Einschubgehäuse drückt, wenn der Arm aus seiner ersten in die zweite Stellung gebracht wird, so daß der Einschub bezüglich des Einschubgehäuses durch einen Hebeleffekt verschoben wird, wobei der Einschub (1) ein erstes Steckerteil (13) besitzt, das elektrisch mit einem zweiten Steckerteil (23) im Gehäuse (2) zusammenwirken soll, und die beiden elektrischen Steckerteile so ausgebildet sind, daß sie sich ineinanderfügen, wobei ein Mittel (12, 24) vorgesehen ist, um die beiden elektrischen Steckerteile in der ineinandergefügten Stellung gegenseitig zu verriegeln, wenn der Einschub in das Gehäuse hineingesteckt ist, wobei das Mittel zur Verriegelung in der eingeschobenen Stellung einen Riegel (24) enthält, der um eine Achse (25) im Einschubgehäuse (2) drehbar montiert ist und elastisch in eine am Einschub (1) vorgesehene Nut (14) gedrückt wird, dadurch gekennzeichnet, daß die Vorrichtung ein Entriegelungsorgan (28) aufweist, das im Gehäuse gleitet und den Riegel (24) um seine Achse drehen kann, so daß er aus der Nut (14) gehoben wird, wobei das Verriegelungsorgan im Inneren des Gehäuses angeordnet ist, so daß es unter der Wirkung einer von dem freien Ende (18) eines Arms (15) des Griffs erzeugten Kraft gleitet, wenn der Griff aus seiner ersten in seine zweite Stellung gebracht wird, wobei die translatorische Bewegung dieses Organs durch einen Anschlag (22) im Gehäuse begrenzt ist.

2. Vorrichtung nach Anspruch 1, in der eine Feder (26) vorgesehen ist, die der translatorischen Verschiebung des Entriegelungsorgans bezüglich des Gehäuses entgegenwirkt.

3. Vorrichtung nach Anspruch 2, in der die Feder (26) auf der Achse (25) des Riegels montiert ist.

## Claims

1. Removable support apparatus for electronic equipment, the apparatus including a drawer (1) received in a cradle (2), the drawer being equipped with a handle (12) having two arms (15), each of which is rotatably mounted about an axis (16), the two arms together taking up a first position in which they extend substantially parallel to one face (17) of the drawer and a second position in which they extend substantially perpendicular to said face of the drawer, the drawer being designed to be inserted into the cradle (2), each arm (15) of the handle having a free end (18) organized to bear against the cradle while said arm is being displaced between its first position and its second position, so as to displace the drawer relative to the cradle by means of a cam effect, in which apparatus the drawer (1) is equipped with a first electrical connector (13) designed to co-operate electrically with a second electrical connector (23) provided on the cradle (2), said first electrical connector and said second electrical connector being organized to be insertable one into the other, and means (14, 24) being provided for locking said first electrical connector and said second electrical connector together in the inserted position, when the drawer is inserted in the cradle, the means for locking the connectors together in the inserted position comprising a catch (24) rotatably mounted about an axis (25) that is secured to the cradle (2), said catch being resiliently urged into a notch (14) provided on the drawer (1), said apparatus being characterized in that it includes an unlocking member (28) slidably mounted inside the cradle, and organized to rotate said catch (24) about its axis so as to release it from the notch (14), said unlocking member being disposed inside the cradle sc as to slide under the effect of a thrust force exerted by the free end (18) of one arm (15) of the handle while said arm is being displaced between its first position and its second position, the displacement in translation of the unlocking member being limited by an abutment (22) that is secured to the cradle.

2. The apparatus according to claim 1, in which a spring (26) is provided to oppose the displacement in translation of the unlocking member relative to the cradle.

3. The apparatus according to claim 2, in which the spring (26) is mounted on the axis (25) of the catch.
